# EUROPÄISCHE PATENTSCHRIFT

(11) **EP 0 578 931 B1**
(45) Veröffentlichungstag und Bekanntmachung des Hinweises auf die Patenterteilung: **17.09.1997**
(21) Anmeldenummer: 93106523.9
(22) Anmeldetag: 22.04.1993
(51) Int. Cl.: G11B 20/10, G11B 27/02, G11C 7/00, G06F 19/00, G11B 20/02, G11B 27/036

(54) **Diktiergerät mit einem Magnetbandspeicher und einem digitalen Speicher**
Dictation apparatus with a magnetic tape memory and a digital memory
Appareil à dicter avec une mémore à bande magnétique et une mémoire numérique

(30) Priorität: 29.04.1992 DE 4214053
(43) Veröffentlichungstag der Anmeldung: 19.01.1994
(73) Patentinhaber: GRUNDIG Aktiengesellschaft, 90762 Fürth (DE)
(72) Erfinder: Keller, Klaus, Dipl.-Ing. (FH), Grundig E.M.V., 90762 Fürth/Bay (DE)

(56) Entgegenhaltungen:
- EP-A- 0 012 864
- EP-A- 0 065 148
- EP-A- 0 406 744
- DE-A- 3 429 769
- DE-A- 4 004 822
- FR-A- 2 606 922
- US-A- 3 930 234
- US-A- 4 430 726

## Beschreibung

Die Erfindung betrifft ein Diktiergerät mit einem Magnetbandspeicher und einem digitalen Speicher gemäß dem Oberbegriff des Patentanspruchs 1.

Diktier- und Schreibgeräte sind im Büro bei der Erstellung von Dokumenten seit langem bewährte Hilfsmittel. Für die wirtschaftliche Abwicklung des gesamten internen und externen Schriftverkehrs ist es besonders wichtig, die Arbeit für den Diktierer und die Sekretärin, Schreibkraft bzw. Phonotypistin zu erleichtern. Beispielsweise soll die Umsetzung des gesprochenen Textes in Schriftform möglichst schnell erfolgen, die Berichtigung einzelner Textpassagen eines diktierten Briefes möglichst einfach durchführbar sein, usw.

Aus der DE-PS 21 59 848 ist ein Textverarbeitungssystem mit peripheren Diktateingabestellen und mit zentral angeordneten Diktatwiedergabe- und Schreibgeräten bekannt. Die über das Fernmeldenetz übertragenen Diktate werden im Schreibsekretariat abgehört und in den geschriebenen Text umgesetzt. Den verschiedenen peripheren Diktateingabestellen und den einzelnen Textabschnitten sind jeweils Kennungen zugeordnet. Die einzelnen Textabschnitte werden automatisch sortiert und zum vollständigen Text zusammengefügt. Eine unmittelbare Überprüfung der in den Textseitenspeichern gespeicherten Textabschnitte und das Vornehmen von Korrekturen, Umstellungen oder Einfügungen vor dem Ausdrucken des Textes wird dem Verfasser des Textes dadurch ermöglicht, daß jede Diktateingabestelle einen Anzeigebildschirm und eine Korrektureinrichtung aufweist. Dadurch ist der jeweils auf dem Bildschirm angezeigte und in dem jeweils zugeordneten Textseitenspeicher gespeicherte Text durch Löschen, Überschreiben, Einfügen von Schriftzeichen oder ähnlichen Operationen korrigierbar.

Ein solches Textverarbeitungssystem in Form einer Zentraldiktatanlage erleichtert zwar dem Diktierer die Arbeit und ermöglicht eine schnelle Textverarbeitung, erfordert jedoch vom Anwender hohe Investitionen. Als Massenspeicher für die Diktate bzw. Diktatabschnitte ist beim Textverarbeitungssystem gemäß der DE-PS 21 59 848 ein Magnetband-Speicher vorgesehen.

Weiterhin sind aus der DE-PS 33 47 231 oder der DE-OS 40 04 822 Diktiergeräte in 2-Spur-Technik (d.h. Aufzeichnung auf dem Magnetband mittels Stereo-Magnetkopf) bekannt. Die Steuerung von Einfügungen und/oder Korrektur auf der zweiten Spur erfolgt anhand auf dem Magnetband aufgezeichneter Marken.

Beispielsweise ist beim Gegenstand der DE-OS 40 04 822 eine Löschtaste vorgesehen, die es ermöglicht, Textteile mit einer Löschmarke zu versehen. Dabei werden diese Textteile in Wirklichkeit nicht gelöscht, sondern im Wiedergabebetrieb übersprungen. In gleicher Weise kann das nachträgliche Verschieben (Umsetzen) von Textteilen vorgenommen werden, d.h. die jeweiligen Textteile werden im schnellen Vor- oder Rücklauf (Vorwärts-/Rückwärtssprung) angefahren und von der jeweiligen Spur abgespielt.

Beim Diktiergerät gemäß der DE-OS 40 04 822 ist auch auf die Möglichkeit hingewiesen worden, anstelle eines Magnetbands Digitalspeichermedien zu benutzen. Die Vorgänge des Einsprechens, Löschens und des Versetzens von Sprachblöcken werden dabei am Bildschirm grafisch dargestellt.

Aus der DE-OS 34 29 769 ist ein Verfahren zur Texteingabe in ein Diktiergerät oder einen Anrufbeantworter bekannt, bei dem ein Halbleiterspeicher benutzt wird. Zur Korrektur von Textstellen bzw. zum Ersetzen von Textstellen durch neue Textteile, werden die Anfangs- und Endpunkte der auszutauschenden, gesprochenen Textteile durch einen Markierungscode bestimmt. Beim Einfügen des Markierungscodes wird jeweils der ursprüngliche Text im Halbleiterspeicher um die Codewortlänge verschoben. Nach der Markierung betätigt der Benutzer eine Korrekturtaste, wodurch eine Korrekturablaufsteuerung entweder die vorletzte Markierung am Ende oder die erste Markierung am Anfang des im digitalen Speicher befindlichen Textes ansteuert. Im seriellen Halbleiterspeicher wird je nach Länge des neuen Textteils der nachfolgende ursprüngliche Text von Speicherplatz zu Speicherplatz weitergeschoben oder aufgeschlossen, wofür der Benutzer eine Fülltaste betätigt.

Diktiergeräte mit einem Halbleiterspeicher bieten zwar dem Benutzer einen guten Bedienkomfort, besonders hinsichtlich der Vornahme von Satzeinschüben, Formulierungskorrekturen, Einfügen längerer Textabschnitte usw., der hierfür vorzusehende Schaltungsaufwand ist jedoch beträchtlich. Bei herkömmlichen Diktiergeräten kann in der Regel auf das Magnetband ein 30-Minuten-Diktat aufgesprochen werden. Wird hierfür ein Halbleiterspeicher benutzt, so ist eine Speicherkapazität von 15 MByte erforderlich. Der weiterhin zusätzlich erforderliche Schaltungsaufwand für die Markiereinrichtung bzw.
Korrekturablaufsteuerung ist ebenfalls hoch, so daß ein Diktiergerät mit einem Halbleiterspeicher entsprechend der Speicherkapazität eine relativ teuere Lösung ist. Werden serielle Halbleiterspeicher eingesetzt, so kann der Benutzer die Korrekturen nur sequentiell, d.h. ausgehend von der letzten zur vorletzten oder von der ersten zur zweiten Korrekturstelle vornehmen.

Auch Geräte, bei denen digitale Speicher und Magnetbandspeicher in Kombination miteinander betrieben werden, sind bekannt.

Das beim Schreib-/Lese-Vorgang in einem Anrufbeantworter angewandte Verfahren, insbesondere die Ausgestaltung der Speicheradressierung beim Aufsprechen des Ansagetextes, ist in der EP-B1-0 012 864 ausführlich beschrieben. Der Festkörperspeicher für den Ansagetext ist wahlweise mit einem Meldetext-Bereich, einem Absagetext-Bereich und einem Beantwortungstext-Bereich oder mit nur einem Ansagetext-Bereich betreibbar. Die einzelnen Speicherbereiche sind direkt adressierbar. Zur Adressierung der Speicherplätze der einzelnen Speicherbereiche (bei der Aufnahme bzw. Wiedergabe der einzelnen Textabschnitte) ist ein Zähler vorgesehen, dem ein Takt zugeführt wird.

Weiterhin ist im Anrufbeantworter ein Magnetbandspeicher angeordnet, welcher zur Aufzeichnung der Nachricht des anrufenden Teilnehmers dient.

Bei Netzausfall (des Lichtnetzes) wird die im flüchtigen Festkörperspeicher (beispielsweise D-RAM, Dynamic Random Access Memory) gespeicherte Ansage gelöscht. Um sicherzustellen, daß bei wiederkehrender Netzspannung die Ansage wieder zur Verfügung steht, wird diese beim Einsprechen in das Mikrofon gleichzeitig im digitalen Speicher und im Magnetbandspeicher gespeichert. Bei Wiederkehr der Netzspannung überträgt die Steuereinrichtung dann mittels eines speziellen Ausfallsteuerprogramms die Ansage vom Magnetbandspeicher in den digitalen Speicher. Zu diesem Zweck ist im Verbindungsweg zwischen dem Ausgang des Magnetbandspeichers (oder A/D-Umsetzers) und Eingang des digitalen Speichers ein Schalter angeordnet. Dieser wird durch die Steuereinrichtung geschlossen, sobald der Magnetbandspeicher am Anfang des Ansagetextes steht.

Um die zur digitalen Speicherung des Sprachsignals im Festkörperspeicher erforderliche Speicherkapazität gering zu halten, wird zur analog-digitalen Umsetzung des Sprachsignals beim Gegenstand der EP-B1-0 012 864 ein Delta-Modulator benutzt. Wie ausführlich erläutert ist, läßt sich dadurch die zur Erzeugung einer guten Sprachqualität erforderliche Datenrate auf ca. 12 kbit/s verringern. Weiterhin ist unmittelbar vor dem Eingang des digitalen Speichers eine Verzögerungsschaltung eingefügt, die das digitale Sprachsignal mindestens um die Ansprechzeit bzw. Detektionszeit einer Diskriminatorschaltung (dient zur Erkennung eines digitalen Sprachsignals) verzögert.

Weiterhin ist aus der DE-OS 39 21 942 eine Schaltungsanordnung zur Überarbeitung eines in einem Magnetband- und/oder Halbleiterspeicher abgespeicherten gesprochenen Textes bekannt. Durch die Kombination von Magnetband- und Halbleiterspeicher werden die Vorzüge beider Speicherfamilien vereinigt und auf überraschend einfache Art und Weise wird eine Arbeitserleichterung sowohl für den Diktierer als auch für die Sekretärin ermöglicht. Der Benutzer kann weitgehend die bei herkömmlichen Diktiergeräten gewohnte Arbeitsweise beibehalten.

Die Speicherkapazität des Halbleiterspeichers ist wesentlich geringer als die des Magnetbandspeichers, z.B. ausreichend für ein 3-Minuten-Diktat. Beim Abhören wird dadurch die Überarbeitung von maximal 3-Minuten-Diktaten ermöglicht.

Bei der ersten Ausführungsform nach DE-OS 39 21 942 wird das Diktat im Halbleiterspeicher zwischengespeichert. Für den Fall, daß die Diktatlänge des Einzel-Diktats einen Grenzwert von z.B. 90% der Speicherkapazität des Halbleiterspeichers überschreitet, wird der Diktierer darauf aufmerksam gemacht. Der Verfasser des Diktats kann nun entweder ohne Abhören des zwischengespeicherten Textes diesen endgültig im Magnetbandspeicher abspeichern oder das Einschreiben in den Magnetbandspeicher folgt nach dem Abhören und ggfs. Überarbeiten des zwischengespeicherten Textes. Der zwischengespeicherte Text wird entweder beim Einschreiben in den Magnetbandspeicher gelöscht oder durch das nachfolgende weitere Diktat überschrieben.

Bei der zweiten Ausführungsform nach der DE-OS 39 21 942 wird der Halbleiterspeicher nur zur Zwischenspeicherung des neuen gesprochenen Textteils eingesetzt. Bei dieser Ausführungsform können ebenfalls Korrekturen in beliebiger Länge und an beliebigen Textstellen vorgenommen werden.

Im Laufe der Weiterentwicklung des Diktiergerätes gemäß der DE-OS 39 21 942 wurde untersucht, ob nicht noch weitere Verbesserungen des Bedienkomforts erreichbar sind. Als nachteilig im praktischen Betrieb stellte sich eine systembedingte Nachlaufzeit heraus. Diese ist durch den Halbleiterspeicher bedingt und für den Benutzer ungewohnt.

Der Erfindung liegt die Aufgabe zugrunde, das Diktiergerät gemäß der DE-OS 39 21 942 derart weiter zu entwickeln, daß ohne Nachlaufzeit die Vornahme von Korrekturen an beliebigen Textstellen und von beliebiger Länge ermöglicht wird.

Die Aufgabe wird bei einem gattungsgemäßen Diktiergerät durch die kennzeichnenden Merkmale des Patentanspruchs 1 gelöst.

Das erfindungsgemäße Diktiergerät ist geeignet zur Verwendung für sprachgesteuerte Aufnahmen ohne Sprachtextverlust. Die parallele serielle Abspeicherung erlaubt eine anschließende Überarbeitung des Sprachtextes, wie Herauslöschen eines Textteiles ohne Zwischenpausen, Einfügen eines Textteiles usw.. Beträgt die Aufzeichnungszeit des digitalen Speichers zwei Minuten, so kann innerhalb dieser zuletzt abgespeicherten zwei Minuten ein Textteil beliebig herausgelöscht oder eingefügt werden. Wird keine Textänderung gewünscht, so ist mit dem Diktatende wie bisher die Aufzeichnung beendet (d.h. trotz des digitalen Speichers ist ein unveränderter Diktierbetrieb möglich).

Die Ausführungsform gemäß Patentanspruch 2 weist den Vorteil auf, daß - anhand der Marken - durch das Überspringen bisher aufgezeichneter Textteile und durch das Einfügen des neuen Textteils am momentanen Diktatende auch sehr lange Einfügungen ermöglicht werden.

Durch das um die Hochlaufzeit versetzte Aufzeichnen des Diktats im Magnetbandspeicher gemäß der Ausführungsform nach Patentanspruch 3 ist nur am Diktatende ein sehr kurzes Nachlaufen erforderlich, welches der laufwerksbedingten Hochlaufzeit entspricht.

Aus der DE-A1 31 26 430 ist ein Diktiergerät bekannt, bei dem sprachaktiviertes Einschalten und Aufzeichnung ohne Textverlust erreicht wird. Hierzu ist u.a. eine Verzögerungsschaltung - beispielsweise in Form einer Eimerkettenschaltung - vorgesehen, welcher das aufzunehmende Signal zugeführt wird. Die Verzögerung wird derart gewählt, daß nach deren Ablauf der Motor zum Magnetbandtransport die vorgeschriebene Geschwindigkeit erreicht hat.

Die Erfindung wird im folgenden anhand einer in der Zeichnung dargestellten Ausführungsform näher beschrieben und erläutert.

Es zeigt:
- Fig. 1: eine Ausführungsform des erfindungsgemäßen Diktiergeräts mit paralleler serieller Abspeicherung des Sprachtextes im Magnetbandspeicher und im digitalen Speicher und
- Fig. 2: schematisch die Steuerungsmöglichkeiten anhand von Marken zum Überarbeiten von Textteilen.

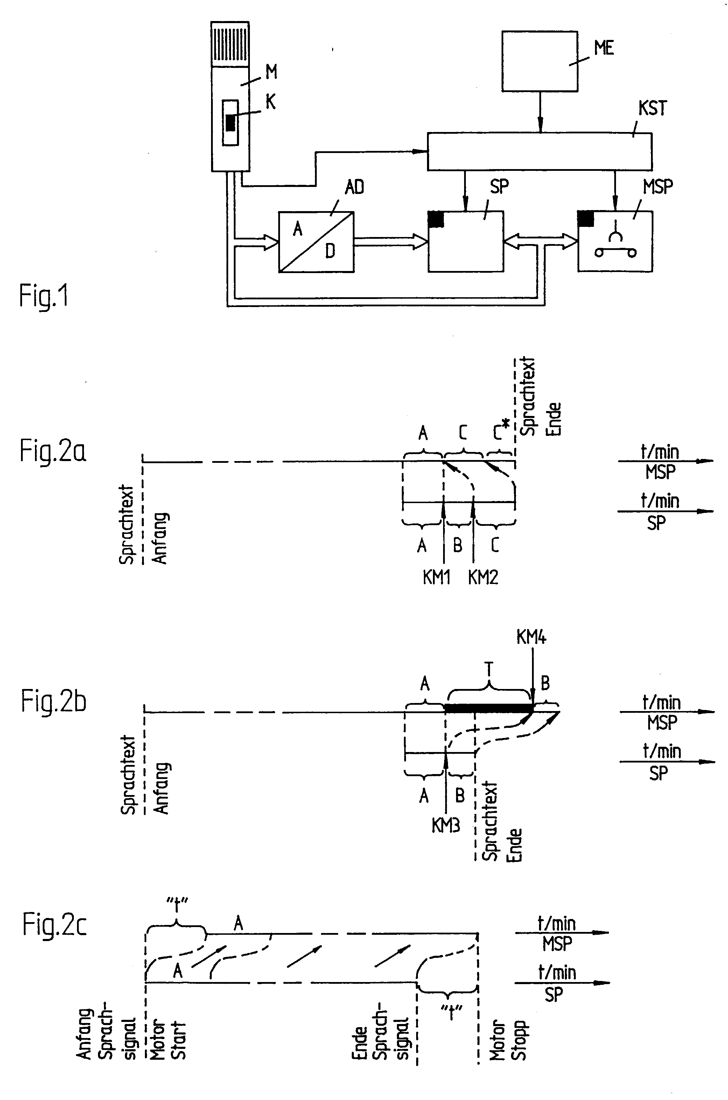

Bei der in Fig. 1 dargestellten Ausführungsform ist ein Magnetbandspeicher MSP und ein Halbleiterspeicher SP zur Speicherung von gesprochenen Texten vorgesehen, wobei eine Analog-Digital-Umsetzung im A/D-Umsetzer AD, des vom Mikrofon M kommenden Sprachsignals vorgenommen wird. Mit einer Korrekturtaste K und einer Markiereinrichtung ME können vom Diktierer zu korrigierende Textteile markiert werden. Weiterhin ist eine Korrektursteuereinrichtung KST vorgesehen. Die Speicherkapazität des Halbleiterspeiches SP ist wesentlich geringer als die Speicherkapazität des Magnetbandspeichers MSP. Auf dem Magnetband kann entweder ein digitales oder ein analoges Sprachsignal aufgezeichnet werden. Wird ein analoges Signal aufgezeichnet, so kann als Wiedergabegerät ein herkömmliches Wiedergabegerät ohne Digital-Analog-Umsetzer eingesetzt werden. Die beim Gegenstand der DE-OS 39 21 942 aufgezeigten Möglichkeiten, wie VSC-Prozessor zum Ausgleich der durch unterschiedliche Schreib-/Lesegeschwindigkeit bedingten Tonhöhenänderung oder Ausgleich der Differenz durch die Sekretärin (± 15% Veränderung der Wiedergabegeschwindigkeit), können beim erfindungsgemäßen Diktiergerät ebenfalls genutzt werden.

Anhand der Fig. 2 wird die neue Betriebsweise des Diktiergeräts im einzelnen beschrieben und erläutert. Wie bereits anhand Fig. 1 erläutert, befindet sich immer die zuletzt erfolgte Sprachtext-Aufzeichnung im digitalen Speicher SP.

In Fig. 2a ist die Betriebsweise "Textteil B löschen" dargestellt. Zuerst sucht der Benutzer durch Rück-/Vorspulen/Start den Textteilanfang im Magnetbandspeicher MSP und markiert diesen Textteilanfang durch Betätigung der Korrekturtaste K; dabei werden Magnetbandspeicher MSP und digitaler Speicher SP synchron zueinander betrieben. Bei der ersten Korrekturmarkierung KM1 bleibt der Magnetbandspeicher MSP stehen. Nun sucht der Benutzer durch Rück-/Vorspulen/Start das Textteilende im digitalen Speicher SP und markiert dieses Textteilende im digitalen Speicher SP durch Betätigen der Korrekturtaste K mit der Korrekturmarkierung KM2. Die Korrekturmarkierung KM2 bewirkt, daß die Korrektursteuerung KST den nach der Korrekturmarkierung KM2 im digitalen Speicher SP befindlichen Textteil C ausliest und in den Magentbandspeicher MSP nach der ersten Korrekturmarkierung KM1 einschreibt. Ist dieser Textteil C kürzer als der zwischen den Korrekturmarkierungen KM1, KM2 ursprünglich sich befindliche und zu löschende Textteil B, so wird dieser Textteil B nur teilweise durch den Textteil C überschrieben. Dieser verbleibende Textteil B kann durch Setzen eines Briefendesignals abgetrennt und/oder durch "Nachlöschen" z.B. um die volle Textlänge von Textteil B beseitigt werden. Wird dagegen das Diktat noch fortgesetzt, so wird ohnehin der Textteil B durch den neuen Sprachtext überschrieben.

In Fig. 2b ist die Betriebsweise "Textteil T einfügen" dargestellt. Zuerst sucht der Benutzer wieder durch Rück-/Vorspulen/Start die Textstelle, wonach der Textteil T eingefügt werden soll und markiert diese Textstelle durch Betätigung der Korrekturtaste K mit der Korrekturmarkierung KM3. Bis zur Korrekturmarkierung KM3 laufen Magnetbandspeicher MSP und digitaler Speicher SP synchron, danach bleibt der digitale Speicher SP an diesem Speicherplatz stehen. Durch Betätigung der Aufnahme/Start-Funktion wird im Magnetbandspeicher MSP der neue Textteil T beliebiger Länge eingefügt, wobei die Aufzeichnungszeit nur begrenzt ist durch die momentane Restspeicherkapazität des Magnetbandspeichers MSP und der restlichen belegten Speicherkapazität des digitalen Speichers SP. In gleicher Weise wird, wie anhand Fig. 2a beschrieben, der ursprüngliche nach der Korrekturmarkierung KM3 im Magnetbandspeicher MSP befindliche Text überschrieben. Durch Betätigung der Korrekturtaste K wird das Ende des Textteils T mit der Korrekturmarkierung KM4 markiert. Die Korrekturmarkierung KM4 bewirkt, daß die Korrektursteuerung KST den nach der Korrekturmarkierung KM3 im digitalen Speicher SP befindlichen Textteil ausliest und nach der Korrekturmarkierung KM4 in den Magnetbandspeicher MSP einschreibt.

Fig. 2c zeigt schließlich wie anhand der beiden Speicher SP und MSP ein sprachaktiviertes Einschalten ohne Textverlust erreicht wird. Magnetbandgeräte benötigen wegen der Massenträgheitsmomente eine endliche Zeit "t" vom Einschalten des Motors bis zum Bandtransport. Wird durch eine elektronische Sprachaktivierungsschaltung der Motor gestartet, so werden die Anfangsssilben oder Wörter am Sprachtextanfang nicht aufgezeichnet. Zur Vermeidung solcher Sprachtextverluste kann der digitale Speicher SP gleichfalls benutzt werden.

Läuft beispielsweise der Speicher SP bei Aufnahme entweder im Endlosbetrieb (d.h. also Magnetbandspeicher) oder als digitaler Speicher (d.h. ohne mechanische Verzögerung), so kann der Sprachtextverlust über den Speicher SP beseitigt werden. Dies wird dadurch erreicht, daß stets der Sprachtext um die Hochlaufzeit "t" versetzt aus dem Speicher SP ausgelesen und in den Magnetbandspeicher MSP eingeschrieben wird. Dadurch ist am Aufnahmeende nur ein sehr kurzes Nachlaufen des Magnetbandspeichers MSP (um die laufwerksbedingte Hochlaufzeit "t") notwendig.

Das erfindungsgemäße Diktiergerät vereinigt die Vorteile beider Speicherfamilien und erlaubt dem Benutzer, bei Beibehaltung seiner gewohnten Arbeitsweise, auch eine sehr umfangreiche Korrektur und Überarbeitung seines Diktats.

Weiterhin ist die Sprachtextnachbearbeitung mit dieser parallelen Schaltungsanordnung auch dadurch möglich, indem zuerst ausschließlich der MSP (Magnetbandspeicher) zur Sprachtextaufzeichnung betrieben wird. Nach Textende, z.B. Aufnahme-Pause/-Stop kann in dem digitalen Speicher SP der nachzubearbeitende Sprachtext während Rücklauf/Review mit erhöhter Geschwindigkeit übertragen werden.

Die weitere Textbearbeitung erfolgt wie bereits beschrieben.

Von Vorteil ist, daß der Speicher SP nur bei Rückspulbetrieb aktiviert wird. Dadurch erfolgt keine zusätzliche Stromaufnahme bei Normalbetrieb, was besonders wichtig bei Batteriebetrieb ist. Der Speicher wird nur bei Bedarf beschrieben. Dadurch können auch Speicher mit begrenzten Schreibzyklen (z.B. Flash-EPROM) eingesetzt werden.

## Patentansprüche

1. Diktiergerät mit einem Magnetbandspeicher (MSP) und einem digitalen Speicher (SP) zur Speicherung von Sprachsignalen, wobei die Speicherkapazität des digitalen Speichers (SP) wesentlich geringer als die des Magnetbandspeichers (MSP) ist und wobei mittels einer Korrektursteuereinrichtung (KST) und einer Markiereinrichtung (ME) die Vornahme von Korrekturen an beliebigen Textstellen ermöglicht wird,
**dadurch gekennzeichnet,** daß der Text beim Einsprechen in ein Mikrofon (M) derart im Magnetbandspeicher (MSP) aufgezeichnet und im digitalen Speicher (SP) gespeichert wird, daß synchron mit der Aufzeichnung im Magnetbandspeicher (MPS) oder mit Wiedergabe von diesem im digitalen Speicher (SP) stets ein fortgeschriebenes digitales Korrekturdoppel bereitgestellt wird und daß mittels einer vom Benutzer betätigbaren Korrekturtaste (K) in Verbindung mit der Korrektursteuereinrichtung (KST) und der Markiereinrichtung (ME) ermöglicht wird, Textteile sowohl des digitalen Speichers (SP) als auch des Magnetbandspeichers (MSP) zur Durchführung von Sprungfunktionen, Löschen und Verschieben mit jeweils einer Marke zu versehen.

2. Diktiergerät nach Anspruch 1,
**dadurch gekennzeichnet,** daß
zum Einfügen eines neuen Textteils das Zuführen des Sprachsignals nur zum Magnetbandspeicher (MSP) anhand von Marken steuerbar ist.

3. Diktiergerät nach Anspruch 1,
**dadurch gekennzeichnet,** daß
zur Vermeidung des Verlustes von Anfangssilben des Diktats infolge einer laufwerksbedingten Hochlaufzeit (t), der Diktatanfang zuerst in den digitalen Speicher (SP) eingeschrieben und dann um die Hochlaufzeit (t) versetzt ausgelesen und im Magnetbandspeicher (MSP) aufgezeichnet wird.

## Claims

1. Dictating machine having a magnetic tape memory (MSP) and a digital memory (SP) for storing speech signals, the memory capacity of the digital memory (SP) being substantially less than that of the magnetic tape memory (MSP) and the carrying out of corrections at any desired text points being made possible by means of a correction control device (KST) and a marking device (ME),
characterized in that, on speaking into a microphone (M), the text is recorded in the magnetic tape memory (MSP) and in the digital memory (SP) in such a way that, synchronously with the recording in the magnetic tape memory (MSP) or with playback from the latter a continued digital duplicate correction is always provided in the digital memory (SP) and that, by means of a correction key (K) operated by the user in conjunction with the correction control device (KST) and the marking device (ME), it is made possible to provide text sections both of the digital memory (SP) and of the magnetic tape memory (MSP) with a mark in each case to carry out step functions, erasure and transposition.

2. Dictating machine according to Claim 1, characterized in that, to insert a new text section, the supply of the speech signal only to the magnetic tape memory (MSP) can be controlled on the basis of marks.

3. Dictating machine according to Claim 1, characterized in that, to avoid the loss of initial syllables of the dictation as a consequence of an acceleration time (t) due to the tape drive mechanism, the start of the dictation is first written into the digital memory (SP) and then read out after being offset by the acceleration time (t) and is recorded in the magnetic tape memory (MSP).

## Revendications

1. Dictaphone comportant une mémoire à bande magnétique (MSP) et une mémoire numérique (SP) pour mémoriser des signaux vocaux, dans lequel la capacité de mémoire de la mémoire numérique (SP) est nettement inférieure à celle de la mémoire à bande magnétique (MSP) et l'exécution de corrections en des emplacements quelconques d'un texte est rendue possible au moyen d'un dispositif (KST) de commande de correction et d'un dispositif de marquage (ME), caractérisé en ce que, lorsqu'il est prononcé dans un microphone (M), le texte est enregistré dans la mémoire à bande magnétique (MSP) et est mémorisé dans la mémoire numérique (SP), qu'une double correction numérique mise à jour est préparée en permanence en synchronisme avec l'enregistrement dans la mémoire à bande magnétique (MSP) ou avec la reproduction de cette dernière dans la mémoire numérique (SP), et qu'à l'aide d'une touche de correction (K), pouvant être actionnée par l'utilisateur, et en liaison avec le dispositif (KST) de commande de correction et le dispositif de marquage (ME) il devient possible d'appliquer une marque respective à des parties de texte aussi bien de la mémoire numérique (SP) que de la mémoire à bande magnétique (MSP) pour l'exécution de fonctions de saut, d'effacements et de décalage.

2. Dictaphone selon la revendication 1, caractérisé en ce que pour l'insertion d'une nouvelle partie de texte, l'envoi du signal vocal uniquement à la mémoire à bande magnétique (MSP) est commandable en fonction de marques.

3. Dictaphone selon la revendication 1, caractérisé en ce que pour éviter la perte de syllabes initiales de la dictée, en raison d'un temps de marche à régime élevé (t) conditionné par le dérouleur, le début de la dictée est enregistré tout d'abord dans la mémoire numérique (SP) et ensuite est lu, en étant décalé du temps (t) de marche à régime élevé, et est enregistré dans la mémoire à bande magnétique (MSP).
